# EUROPEAN PATENT SPECIFICATION

(11) **EP 2 078 706 B1**
(45) Date of publication and mention of the grant of the patent: **08.03.2017**
(21) Application number: 09000425.0
(22) Date of filing: 14.01.2009
(51) Int. Cl.: C09D 183/02, H01L 31/18, G02B 27/00, C03C 1/00, C03C 17/00, C03C 17/02, C03C 17/25, C09D 183/06, H01L 31/0216

(54) **METHODS OF MAKING SILICA-TITANIA COATINGS, AND PRODUCTS CONTAINING THE SAME**
VERFAHREN ZUR HERSTELLUNG VON SILICIUMDIOXIDBESCHICHTUNGEN UND PRODUKTE DAMIT
PROCÉDÉS DE FABRICATION DE REVÊTEMENTS EN SILICE-TITANE, ET PRODUITS LES CONTENANT

(30) Priority: 14.01.2008 US 7699
(43) Date of publication of application: 15.07.2009
(73) Proprietor: Guardian Industries Corp., Auburn Hills, MI 48326-1714 (US)
(72) Inventor: Sharma, Pramod K., Ann Arbor, Michigan 48105 (US)
(74) Representative: Hess, Peter K. G.

(56) References cited:
- EP-A- 1 016 637
- US-A- 4 361 598
- US-A- 4 694 218
- US-A- 5 328 975
- US-A- 6 013 372
- US-A1- 2004 071 986
- US-A1- 2007 074 757

## Description

Certain example embodiments of this invention relate to silica-titania coatings that may have antireflective, hydrophilic and/or super hydrophilic properties. In certain example embodiments of this invention, such hydrophilic coatings may be used in photovoltaic devices, antifog mirrors, storefront windows, display cases, picture frames, greenhouses, other types of windows, or in any other suitable application.

### BACKGROUND AND SUMMARY OF PREFERRED EMBODIMENTS

Hydrophilic coatings (e.g., coatings with a low contact angle) may be useful for self-cleaning surfaces as well as in anti-fog and/or anti-mist applications. Antireflective coatings may be useful for photovoltaic devices and other applications in which reflection of electromagnetic radiation is preferably avoided.

Photovoltaic devices such as solar cells (and modules therefor) are known in the art. Glass is an integral part of most common commercial photovoltaic modules, including both crystalline and thin film types. A solar cell/module may include, for example, a photoelectric transfer film made up of one or more layers located between a pair of substrates. One or more of the substrates may be of glass, and the photoelectric transfer film (typically semiconductor) is for converting solar energy to electricity. Example solar cells are disclosed in U.S. Patent Nos. 4,510,344, 4,806,436, 6,506,622, 5,977,477, and JP 07-122764.

For photovoltaic (PV) applications - that is, in applications involving photovoltaic modules - the reflection of glass is preferably minimized. It is clear the power output of the module is dependant upon the amount of light (e.g., the number of photons) within the solar spectrum that passes through the glass and reaches the PV semiconductor. Therefore, numerous attempts have been made to try to boost overall solar transmission through glass used in PV-modules.

Document US 5,328,975 discloses an organo alcoxylane/metal oxide sol gel composition which is hydrolyzed, dried and heat-treated to form a silicon oxide/titanium oxide abrasion-resistant coating on a substrate with high ultraviolet radiation absorbance.

Document US 4,694,218 relates to a coating for reducing reflection on optical glass screens comprising a partially hydrolyzed metal alkoxide polymer. The coating is applied by coating a solution of the coating mixture onto a glass screen and by heat-treating the coating at a temperature high enough to drive off the solvent and bond the coating mixture to the glass surface.

US 4,361,598 likewise relates to polymerized solutions for depositing optical oxide coatings on glass substrates. According to this document, solutions are prepared by reacting metal alkoxide with a mixture of critical amounts of water and/or acid in an alcohol medium and by applying the coating mixture with spin application on a substrate.

One attempt relates to the use of iron-free or "clear" glass, which may increase the amount of solar light transmission when compared to regular float glass, through absorption minimization. Solar transmission may be further increased by the use of an antireflective (AR) coating on the first surface of the glass. Porous silica has been used as an AR coating on a glass substrate. But AR coatings derived from porous silica may be difficult to keep clean due to the possible a presence of a large amount of pores in structure.

Therefore, there may be a need to include a antireflective coating that has a superhydrophilic property. Such a coating may be highly durable and/or self cleaning and may be used PV superstrate. The above needs are met by a method according to claim 1.

In certain embodiments, this invention may relate to the formulation and manufacture of an AR coating based on porous silica with superhydrophillic characteristics.

In a certain example embodiment, there is a method of making a coated article including a low-index coating having antireflective and hydrophilic properties, the method comprising: forming a silica sol by mixing glycydoxypropyltrimethoxysilane with a first solvent, a first catalyst, water, and a colloidal silica; forming a titania sol by mixing titanium tetra-isobutoxide with a second solvent, a second catalyst, and water; mixing the silica sol and the titania sol, either before or concurrently with the formation of the silica sol and the titania sol; casting the mixture by spin coating to form a coating on a substrate; and curing and heat treating the coating so as to form a low-index and hydrophilic layer on the substrate. A sessile drop of water in contact with the low-index and hydrophilic layer may exhibit a contact angle of less than or equal to 25 degrees.

In certain embodiments, there is a method of making a photovoltaic device comprising a photoelectric transfer film, at least one electrode, and a low-index coating, wherein the method of making the photovoltaic device comprises making a coated article comprising a silica- and titania-based antireflective and hydrophilic coating layer, and wherein the low-index and hydrophilic layer is provided on a light incident side of a front glass substrate of the photovoltaic device.

In certain embodiments, there is a method of making a coated article including a low-index coating having antireflective and hydrophilic properties, the method comprising: forming a silica/titania precursor comprising a silica sol comprising a silane and/or a colloidal silica and a titania sol comprising a titanium organometallic compound; and depositing the silica/titania precursor on a glass substrate to form a coating layer; curing and/or firing the coating layer in an oven at a temperature of from about 550 to 700°C for a duration of from about 1 to 10 minutes; wherein a sessile drop of water in contact with the coating layer exhibits a contact angle of less than or equal to 25 degrees.

In certain embodiments, there is a method of making a photovoltaic device including a low-index silica- and titania-based coating used in an antireflective and hydrophilic layer, the method comprising: forming a silica-titania precursor comprising (i) a silica sol comprising a silane and/or a colloidal silica and (ii) a titania sol comprising a titanium organometallic compound; depositing the silica-titania precursor on a glass substrate to form a coating layer; curing and/or firing the coating layer in an oven at a temperature of from about 550 to 700°C for a duration of from about 1 to 10 minutes; and using the glass substrate with the coating layer thereon as a front glass substrate of the photovoltaic device so that the low-index silica- and titania-based coating is provided on a light incident side of the glass substrate.

In certain embodiments, there is a photovoltaic device comprising: a photovoltaic film, and at least a glass substrate on a light incident side of the photovoltaic film; an antireflection and hydrophilic coating provided on the glass substrate; wherein the antireflection and hydrophilic coating comprises at least a layer provided directly on and contacting the glass substrate, the layer produced using a method comprising the steps of: forming a silica-titania precursor comprising (i) a silica sol comprising a silane and/or a colloidal silica and (ii) a titania sol comprising a titanium organometallic compound; depositing the silica-titania precursor on a glass substrate to form a coating layer; and curing and/or firing the coating layer in an oven at a temperature of from about 550 to 700°C for a duration of from about 1 to 10 minutes.

In certain embodiments, there is a coated article comprising: a glass substrate; an antireflection and hydrophilic coating provided on the glass substrate; wherein the antireflection and hydrophilic coating comprises at least a layer provided directly on and contacting the glass substrate, the layer produced using a method comprising the steps of: forming a silica-titania precursor comprising (i) a silica sol comprising a silane and/or a colloidal silica and (ii) a titania sol comprising a titanium organometallic compound; depositing the silica-titania precursor on a glass substrate to form a coating layer; and curing and/or firing the coating layer in an oven at a temperature of from about 550 to 700°C for a duration of from about 1 to 10 minutes; wherein a sessile drop of water in contact with the coating layer exhibits a contact angle of less than or equal to 25 degrees.

### BRIEF DESCRIPTION OF THE DRAWINGS

FIGURE 1 is a generically illustrates a substrate and fluid drop (e.g., a sessile drop of water), and contact angle θ formed between the drop and substrate.
FIGURE 2 generically illustrates an example embodiment of the present invention including a hydrophilic contact angle θ.
FIGURE 3 generically illustrates a cross-sectional view of a photovoltaic device (e.g., solar cell), for converting light to electricity, according to an example embodiment of this invention.
FIGURE 4 illustrates optical spectra in accordance with example embodiments of the present invention.
FIGURE 5 illustrates contact angles of example embodiments of the present invention.

### DETAILED DESCRIPTION OF THE INVENTION

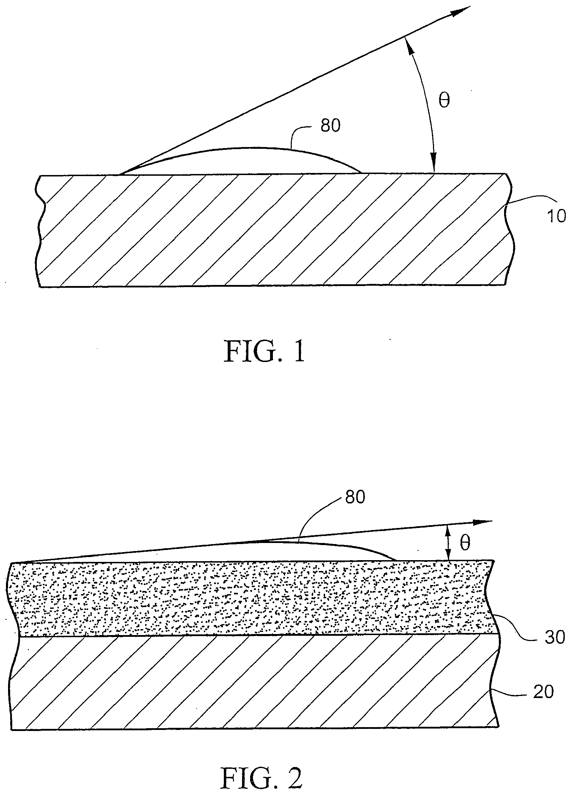

Figure 1 generically illustrates a substrate 10 (e.g., plastic or glass substrate) and fluid drop 80 (e.g., a sessile drop of water) on the substrate 10, and contact angle θ formed between drop 80 and substrate 10. Hydrophilic performance in any of the described and claimed embodiments is a function of contact angle θ, surface energy Υ, and/or wettability or adhesion energy W. The surface energy Υ of substrate 10 may be calculated by measuring its contact angle θ.

Figure 2 generically illustrates an embodiment of a coated article according to an aspect of the present invention. Substrate 20 supports a antireflective/hydrophilic coating layer 30 that includes silica-titania. Substrate 20 may, for example, comprise glass (e.g., soda-lime glass) and/or plastic. Substrate 20 may, for example, consist of a single material. Alternatively, substrate 20 may comprise multiple materials, preferably in layers. Although substrate 20 is depicted as directly supporting (that is, in direct contact with) antireflective/hydrophilic layer 30, indirect or partial support are also contemplated. That is, layer 30 may or may not be in direct contact with substrate 20 in different embodiments of this invention (e.g., there may be other layer(s) therebetween).

In some embodiments, the substrate comprises ordinary float glass, which may include additional amounts of soda (Na₂O), usually in the form of sodium carbonate or nitrate during the production process, lime (CaO) and other oxides (usually aluminum and magnesium oxides) to form a soda-lime-silica structure known colloquially as soda-lime glass. Other glass substrates can be prepared by the introduction of other additives and constituents.

As illustrated in Figure 2, a sessile drop of water 80 in contact with antireflective/hydrophilic layer 30 may exhibit a contact angle θ preferably less than or equal to about 25 degrees, more preferably less than or equal to about 20 degrees, more preferably less than or equal to about 15 degrees, and even more preferably less than or equal to about 10 degrees, in certain example embodiments of this invention.

In some aspects, this invention relates to antireflective/hydrophilic coatings that may be provided for in coated articles used in devices such as photovoltaic devices, antifog mirrors, storefront windows, display cases, picture frames, greenhouses, other types of windows, and the like. In certain example embodiments (e.g., in photovoltaic devices), the antireflective/hydrophilic coating may be provided on either the light incident side or the other side of a substrate (e.g., glass substrate), such as a front glass substrate of a photovoltaic device. In other example embodiments, the antireflective/hydrophilic coatings described herein may be used in the context of sport and stadium lighting (as an antireflective/hydrophilic coating on such lights), and/or street and highway lighting (as an antireflective/hydrophilic coating on such lights).

In certain example embodiments of this invention, an improved antireflective/hydrophilic coating is provided on an incident glass substrate of a solar cell or the like. This antireflective/hydrophilic coating may function to reduce reflection of light from the glass substrate, thereby allowing more light within the solar spectrum to pass through the incident glass substrate and reach the photovoltaic semiconductor so that the solar cell can be more efficient. In other example embodiments of this invention, such an antireflective/hydrophilic coating is used in applications other than photovoltaic devices (e.g., solar cells), such as in storefront windows, display cases, picture frames, greenhouse glass/windows, solariums, other types of windows, and the like. The glass substrate may be a glass superstrate or any other type of glass substrate in different instances.

In certain example embodiments, the antireflective/hydrophilic coating may facilitate self-cleaning of the substrate, possibly inhibiting the agglomeration of water (or the like) on the surface of the substrate..

In certain example embodiments of this invention, high transmission low-iron glass may be used for glass substrate in order to further increase the transmission of radiation (e.g., photons) to the active layer of the solar cell or the like. For example and without limitation, the glass substrate may be of any of the glasses described in any of U.S. Patent Application Serial Nos. 11/049,292 and/or 11/122,218. Furthermore, additional suitable glasses include, for example (i.e., and without limitation): standard clear glass; and/or low-iron glass, such as Guardian's ExtraClear, UltraWhite, or Solar. No matter the composition of the glass substrate, certain embodiments of antireflective/hydrophilic coatings produced in accordance with the present invention may increase transmission of light to the active semiconductor film of the photovoltaic device.

Certain glasses for a glass substrate (which or may not be patterned in different instances) according to example embodiments of this invention utilize soda-lime-silica flat glass as their base composition/glass. In addition to base composition/glass, a colorant portion may be provided in order to achieve a glass that is fairly clear in color and/or has a high visible transmission. An exemplary soda-lime-silica base glass according to certain embodiments of this invention, on a weight percentage basis, includes the following basic ingredients: SiO₂, 67-75% by weight; Na₂O, 10-20% by weight; CaO, 5-15% by weight; MgO, 0-7% by weight; Al₂O₃, 0-5% by weight; K₂O, 0-5% by weight; Li₂O, 0-1.5% by weight; and BaO, 0-1%, by weight.

Other minor ingredients, including various conventional refining aids, such as SO₃, carbon, and the like may also be included in the base glass. In certain embodiments, for example, glass herein may be made from batch raw materials silica sand, soda ash, dolomite, limestone, with the use of sulfate salts such as salt cake (Na₂SO₄) and/or Epsom salt (MgSO₄ x 7H₂O) and/or gypsum (e.g., about a 1:1 combination of any) as refining agents. In certain example embodiments, soda-lime-silica based glasses herein include by weight from about 10-15% Na₂O and from about 6-12% CaO, by weight.

In addition to the base glass above, in making glass according to certain example embodiments of the instant invention the glass batch includes materials (including colorants and/or oxidizers) which cause the resulting glass to be fairly neutral in color (slightly yellow in certain example embodiments, indicated by a positive b* value) and/or have a high visible light transmission. These materials may either be present in the raw materials (e.g., small amounts of iron), or may be added to the base glass materials in the batch (e.g., cerium, erbium and/or the like). In certain example embodiments of this invention, the resulting glass has visible transmission of at least 75%, more preferably at least 80%, even more preferably of at least 85%, and most preferably of at least about 90% (Lt D65). In certain example non-limiting instances, such high transmissions may be achieved at a reference glass thickness of about 3 to 4 mm In certain embodiments of this invention, in addition to the base glass, the glass and/or glass batch comprises or consists essentially of materials as set forth in Table 1 below (in terms of weight percentage of the total glass composition):

**Table 1: Example Additional Materials In Glass**

| Ingredient | General (wt%) | More Preferred | Most Preferred |
|---|---|---|---|
| Total Iron (expressed as Fe₂O₃) | 0.001-0.06% | 0.005-0.04% | 0.01-0.03% |
| Cerium Oxide | 0-0.30% | 0.01-0.12% | 0.01-0.07 |
| TiO₂ | 0-1.0% | 0.005-0.1% | 0.01-0.04% |
| Erbium Oxide | 0.05-0.5% | 0.1-0.5% | 0.1-0.35% |

In certain example embodiments, the total iron content of the glass is more preferably from 0.01 to 0.06%, more preferably from 0.01 to 0.04%, and most preferably from 0.01 to 0.03%. In certain example embodiments of this invention, the colorant portion is substantially free of other colorants (other than potentially trace amounts). However, it should be appreciated that amounts of other materials (e.g., refining aids, melting aids, colorants and/or impurities) may be present in the glass in certain other embodiments of this invention without taking away from the purpose(s) and/or goal(s) of the instant invention. For instance, in certain example embodiments of this invention, the glass composition is substantially free of, or free of, one, two, three, four or all of: erbium oxide, nickel oxide, cobalt oxide, neodymium oxide, chromium oxide, and selenium. The phrase "substantially free" means no more than 2 ppm and possibly as low as 0 ppm of the element or material. It is noted that while the presence of cerium oxide is preferred in many embodiments of this invention, it is not required in all embodiments and indeed is intentionally omitted in many instances. However, in certain example embodiments of this invention, small amounts of erbium oxide may be added to the glass in the colorant portion (e.g., from about 0.1 to 0.5% erbium oxide).

The total amount of iron present in the glass batch and in the resulting glass, i.e., in the colorant portion thereof, is expressed herein in terms of Fe₂O₃ in accordance with standard practice. This, however, does not imply that all iron is actually in the form of Fe₂O₃ (see discussion above in this regard). Likewise, the amount of iron in the ferrous state (Fe⁺²) is reported herein as FeO, even though all ferrous state iron in the glass batch or glass may not be in the form of FeO. As mentioned above, iron in the ferrous state (Fe²⁺; FeO) is a blue-green colorant, while iron in the ferric state (Fe³⁺) is a yellow-green colorant; and the blue-green colorant of ferrous iron is of particular concern, since as a strong colorant it introduces significant color into the glass which can sometimes be undesirable when seeking to achieve a neutral or clear color.

It is noted that the light-incident surface of the substrate may be flat or patterned in different example embodiments of this invention.

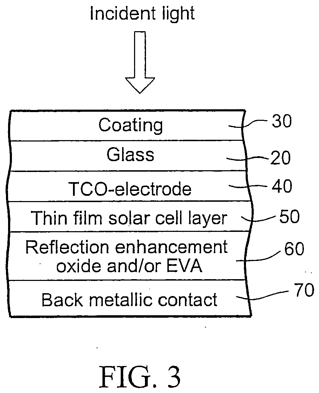

Figure 3 is a cross-sectional view of a photovoltaic device (e.g., solar cell), for converting light to electricity, according to an example embodiment of this invention. The solar cell of Figure 3 uses a antireflective/hydrophilic coating and glass substrate (e.g., as illustrated in Figure 2) in certain example embodiments of this invention. In this example embodiment, the incoming or incident light from the sun or the like is first incident on antireflective/hydrophilic coating 30, passes therethrough and through glass substrate 20 and front transparent electrode 40 before reaching the photovoltaic semiconductor (active film) 50 of the solar cell. Note that the solar cell may also include, but does not require, a reflection enhancement oxide and/or EVA film 60, and/or a back metallic contact and/or reflector 70 as shown in example Figure 3. Other types of photovoltaic devices may of course be used, and the Figure 3 device is merely provided for purposes of example and understanding. As explained above, the antireflective/hydrophilic coating 30 reduces reflections of the incident light (and inhibits agglomeration of large water droplets) and permits more light to reach the thin film semiconductor film 50 of the photovoltaic device thereby permitting the device to act more efficiently.

While certain of the antireflective/hydrophilic coatings discussed above are used in the context of the photovoltaic devices/modules, this invention is not so limited. Antireflective/hydrophilic coatings according to this invention may be used in many other applications, such as, for example, picture frames, fireplace doors, greenhouses, and the like.

In inventive embodiments, the antireflective/hydrophilic coating is made using a sol-gel process involving a silica sol and a titania sol.

In certain example embodiments of this invention, the coating may be based, at least in part, on a silica sol comprising two different silica precursors, namely (a) a stabilized colloidal silica including or consisting essentially of particulate silica in a solvent and (b) a polymeric solution including or consisting essentially of silica chains. In certain embodiments of this invention, the coating may also be based, at least in part, on a titania sol comprising a titanium organometallic precursor.

In exemplary embodiments, the precursor materials may be optionally combined with solvents, anti-foaming agents, surfactants, etc., to adjust rheological characteristics and other properties as desired. In a preferred embodiment, use of reactive diluents may be used to produce formulations containing no volatile organic matter. Some embodiments may comprise colloidal silica dispersed in monomers or organic solvents. Depending on the particular embodiment, the weight ratio of colloidal silica and other silica precursor materials may be varied. Similarly (and depending on the embodiment), the weight percentage of solids in the coating formulation may be varied.

In accordance with certain embodiments of the present invention, suitable solvents may include, for example, n-propanol, isopropanol, other well-known alcohols (e.g., ethanol), and other well-known organic solvents (e.g., toluene).

In an exemplary embodiment, the sol-gel process used in forming the antireflective/hydrophilic coating may comprise: forming a polymeric component of silica by mixing glycydoxypropyltrimethoxysilane (which is sometimes referred to as "glymo") with a solvent, a catalyst, and water; forming a silica sol gel by mixing the polymeric component with a colloidal silica and a second solvent; forming a titania sol gel by mixing titanium organometallic compound with a solvent, a catalyst, and water; mixing the silica sol gel and titania sol gel; casting the mixture by spin coating to form a coating on a substrate; and curing and heat treating the coating.

In certain embodiments, the silica sol may comprise 1-10 wt% (and all subranges therebetween), 2-8 wt% (and all subranges therebetween), or 4-6 wt% polymeric silica (e.g., glymo). The silica sol may comprise 0.1-5 wt% (and all subranges therebetween), 1-3 wt% (and all subranges therebetween), or 1.5-2.5 wt% (and all subranges therebetween) colloidal silica. The titania sol may comprise 1-10 wt% (and all subranges therebetween), 4-7 wt% (and all subranges therebetween), or 5-6 wt% titanium organometallic compound (e.g., titanium tetra-isobutoxide). Because the ratio of silica sol to titania sol may vary, the weight percentages of polymeric silica, colloidal silica, and titanium in the silica/titania sol mixture may also vary. According to the invention, the mixture comprises 10-20 wt% (and all subranges therebetween) of a mixture of titania sol and silica sol. For example, the titanium may comprise, in certain embodiments, 0.01-5 wt% (and all subranges therebetween), 0.1-2 wt% (and all subranges therebetween), or 0.25-1 wt% (and all subranges therebetween) of the titania/silica sol mixture.

Suitable catalysts may include, for example, well-known acids, such as hydrochloric acid, sulfuric acid, acetic acid, nitric acid, etc. The colloidal silica may comprise, for example, silica and methyl ethyl ketone. The mixing of the silica sol and titania sol may occur at or near room temperature for 15 to 45 minutes (and preferably around 30 minutes) or any other period sufficient to mix the two sols either homogeneously or nonhomogeneously.

The curing may occur at a temperature between 100 and 150°C for up to 2 minutes, and the heat treating may occur at a temperature between 550 and 750°C for up to 10 minutes. The curing and/or firing may occur for any suitable length of time, and shorter and longer times with higher and lower temperatures are contemplated within exemplary embodiments of the present invention.

Several examples were prepared, so as to illustrate exemplary embodiments of the present invention. Unless indicated otherwise, all chemicals are available from Aldrich. Although the examples describe the use of the spin-coating method, the uncured coating may be deposited in any suitable manner, including, for example, not only by spin-coating but also roller-coating, spray-coating, and any other method of depositing the uncured coating on a substrate.

Similarly, although the examples describe the use of float glass as the substrate, any suitable substrate may be used in certain embodiments of the present invention.

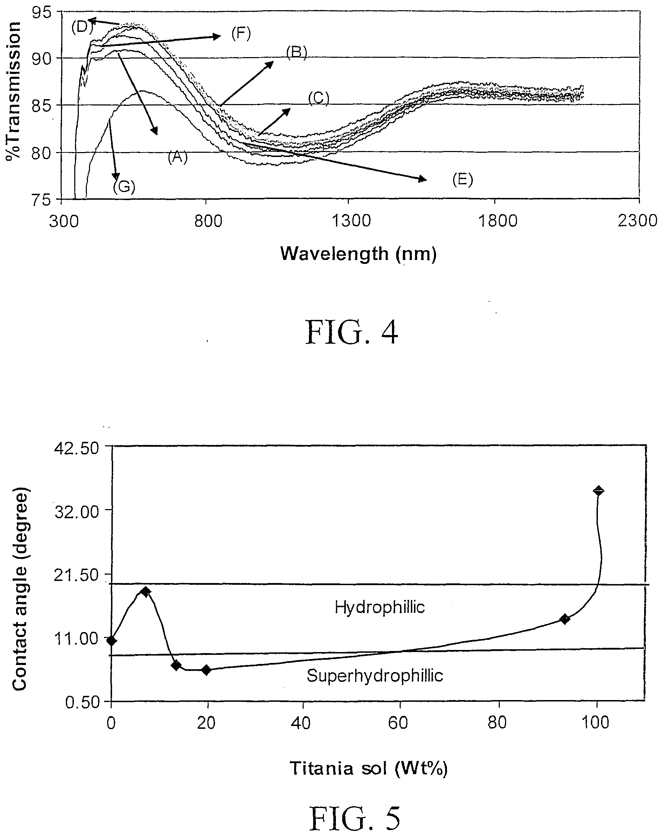

Figure 4, which is mentioned in the following examples, illustrates the optical spectra of (A) Float glass without coatings, (B) coating of Example #1, (C) coating of Example #2, (D) coating of Example #3, (E) coating of Example #4, (F) coating of Example #5, and (G) coating of Example #6.

### Silica Sol:

The silica sol was prepared as follows. A polymeric component of silica was prepared by using 64%wt of n-propanol, 24%wt of glycydoxylpropyltrimethoxysilane (glymo), 7%wt of water and 5%wt of hydrochloric acid. These ingredients were mixed for 24 hrs. The coating solution was prepared by using 21%wt of polymeric solution, 7%wt colloidal silica in methyl ethyl ketone supplied by Nissan Chemicals Inc, and 72%wt n-propanol. This was stirred for 2hrs. The final solution is referred to as a silica sol.

### Titania Sol:

The titania sol was prepared by using 93.49%wt of n-propanol, 5.6%wt of titanium tetra-isobutoxide, 0.44%wt of water, and 0.44%wt of hydrochloric acid. These ingredients were mixed for 4 hrs. The final solution is referred to as a titania sol.

### Example #1 (reference example)

The silica coating was fabricated using spin coating method with 1000 rpm for 18 secs. The coating was heat treated in furnace at 625°C for three and a half minutes. Table 2 indicates the optical average transmission in the range of 400nm to 1200nm wavelength. Figure 4 indicates an optical spectra of the coating and the substrate (i.e. float glass). The average contact angle of the coating is 10.50° as shown in the Table 2 and Figure 5.

### Example #2 (reference example)

Example #2 is the same as Example #1 except the silica and titania sol were taken in 93.33 and 6.67 percent weight, respectively. Table 2 indicates the optical average transmission in the range of 300nm to 1200nm wavelength. Figure 4 indicates an optical spectra of the coating and the substrate (i.e., float glass). The average contact angle of the coating is 18.42° as shown in Table 2 and Figure 5.

### Example #3

Example #3 is the same as Example #1 except the silica and titania sol were taken in 86.66 and 13.34 percent weight, respectively. Table 2 indicates the optical average transmission in the range of 300nm to 1200nm wavelength. Figure 4 indicates an optical spectra of the coating. The average contact angle of the coating is 6.28° as shown in Table 2 and Figure 5.

### Example #4

Example #4 is the same as Example #1 except the silica and titania sol were taken in 80.33 and 19.67 percent weight, respectively. Table 2 indicates the optical average transmission in the range of 300nm to 1200nm wavelength. Figure 4 indicates an optical spectra of the coating. The average contact angle of the coating is 5.47° as shown in Table 2 and Figure 5.

### Example #5 (reference example)

Example #5 is the same as Example #1 except the silica and titania sol were taken in 6.66 and 93.34 percent weight, respectively. Table 2 indicates the optical average transmission in the range of 300nm to 1200nm wavelength. Figure 4 indicates an optical spectra of the coating. The average contact angle of the coating is 13.83° as shown in Table 2 and Figure 5.

### Example #6 (reference example)

Example #6 is the same as Example #1 except it has 100%wt titania sol. Table 2 indicates the optical average transmission in the range of 300nm to 1200nm wavelength. Figure 4 indicates an optical spectra of the coating. The average contact angle of the coating is 35.02° as shown in Table 2 and Figure 5.

Table 2 summarizes the example embodiments and provides results of tested properties of the following examples.

**Table 2: Properties of Examples**

| Example | Si-sol (wt%) | Ti-sol (wt%) | Thickness | %T | | | Contact Angle |
|---|---|---|---|---|---|---|---|
| | | | Å (Average) | Uncoated | Coated | Gain | Degree (Average) |
| Float Glass | 0 | 0 | | 84.12 | 84.12 | 0.00 | 31.03 |
| Example #1 | 100 | 0 | 1452.67 | 84.44 | 86.85 | 2.41 | 10.50 |
| Example #2 | 93.33 | 6.67 | 1077.00 | 84.44 | 86.75 | 2.31 | 18.42 |
| Example #3 | 86.66 | 13.34 | 1226.67 | 84.44 | 86.57 | 2.13 | 6.28 |
| Example #4 | 80.33 | 19.67 | 994.00 | 84.44 | 86.29 | 1.85 | 5.47 |
| Example #5 | 6.66 | 93.34 | 782.00 | 84.44 | 85.38 | 0.94 | 13.83 |
| Example #6 | 0 | 100 | 612.36 | 84.44 | 81.70 | -2.74 | 35.02 |

In accordance with exemplary embodiments, it may be possible to achieve high hydrophilicity when combining a silica sol with a titania sol. For example, there may be an approximately 2.31% transmission gain with a contact angle of 18.42 degrees when 6.67 %wt titania sol added to a balance of a silica sol. For another example, there may be an approximately 2.13% transmission gain with a contact angle of 6 degrees when 13.34 %wt titania sol added a balance of a silica sol. For yet another example, there may be an approximately 1.8% transmission gain with contact angle of less than 5.5 degrees when 19.67 %wt titania sol added to a balance of a silica sol.

As described and claimed herein, all numerical values and ranges of numerical values are approximate and thus include a reasonable or insignificant amount of deviation from the stated numerical values.

While the invention has been described in connection with what is presently considered to be the most practical and preferred embodiment, it is to be understood that the invention is not to be limited to the disclosed embodiment, but on the contrary, is intended to cover various modifications and equivalent arrangements included within the scope of the appended claims.

## Claims

1. A method of making a coated article including a low-index coating having antireflective and hydrophilic properties, the method comprising:
forming a silica sol by mixing glycydoxypropyltrimethoxysilane with at least a first solvent, a first catalyst, water, and a colloidal silica;
forming a titania sol by mixing titanium tetra-isobutoxide with at least a second solvent, a second catalyst, and water;
mixing the silica sol and the titania sol, wherein the silica sol and titania sol are present in the mixture in a weight ratio of between 90:10 and 80:20;
casting the mixture by spin coating to form a coating on a glass substrate;
curing and heat treating the coating on the substrate so as to form a low-index hydrophilic layer on the substrate;
wherein, following the heat treating, a sessile drop of water in contact with the low-index hydrophilic layer exhibits a contact angle of less than or equal to 25 degrees.

2. The method of claim 1, wherein the first solvent and second solvent comprise n-propanol.

3. The method of claim 1, wherein the first catalyst and second catalyst comprise hydrochloric acid.

4. The method of claim 1, wherein the contact angle of less than or equal to 20 degrees, preferably wherein the contact angle is less than or equal to 15 degrees, and most preferably wherein the contact angle is less than or equal to 10 degrees.

5. The method of claim 1, wherein the glass substrate comprises float glass.

6. A method of making a photovoltaic device comprising a photoelectric transfer film, at least one electrode, and a low-index coating, wherein the method of making the photovoltaic device comprises making the coated article according to claim 1, and wherein the low-index and hydrophilic layer is provided on a light incident side of a front glass substrate of the photovoltaic device.

## Patentansprüche

1. Ein Verfahren zur Herstellung eines beschichteten Gegenstands beinhaltend eine Beschichtung mit niedrigem Index, welche anti-reflektierende und hydrophile Eigenschaften aufweist, das Verfahren aufweisend:
Bilden eines Kieselsols durch Mischen von Glycidoxypropyltrimethoxysilan mit zumindest einem ersten Lösungsmittel, einem ersten Katalysator, Wasser und einer Kolloid-Kieselerde;
Bilden eines Titandioxidsols durch Mischen von Titan tetra-isobutoxid mit zumindest einem zweiten Lösungsmittel, einem zweiten Katalysator und Wasser;
Mischen des Kieselsols und des Titandioxidsols, wobei das Kieselsol und das Titandioxidsol in dem Gemisch mit einem Gewichtsverhältnis zwischen 90:10 und 80:20 vorliegen;
Verteilen des Gemischs durch Rotationsbeschichtung, um eine Beschichtung auf einem Glassubstrat zu bilden;
Aushärten und Wärmebehandeln der Beschichtung auf dem Substrat, um eine hydrophile Schicht mit niedrigem Index auf dem Substrat zu bilden;
wobei nach der Wärmebehandlung ein ruhender Wassertropfen, der die hydrophile Schicht mit niedrigem Index kontaktiert einen Kontaktwinkel von kleiner oder gleich 25 Grad aufweist.

2. Das Verfahren gemäß Anspruch 1, wobei das erste Lösungsmittel und das zweite Lösungsmittel n-Propanol umfassen.

3. Das Verfahren gemäß Anspruch 1, wobei der erste Katalysator und der zweite Katalysator Salzsäure umfassen.

4. Das Verfahren gemäß Anspruch 1, wobei der Kontaktwinkel kleiner oder gleich 20 Grad ist, wobei der Kontaktwinkel vorzugsweise kleiner oder gleich 15 Grad ist und wobei der Kontaktwinkel am meisten bevorzugt kleiner oder gleich 10 Grad ist.

5. Das Verfahren gemäß Anspruch 1, wobei das Glassubstrat Floatglas umfasst.

6. Ein Verfahren zur Herstellung einer Photovoltaikvorrichtung, aufweisend eine photoelektrische Transferfolie, zumindest eine Elektrode und eine Beschichtung mit niedrigem Index, wobei das Verfahren zur Herstellung der Photovoltaikvorrichtung die Herstellung des beschichteten Gegenstands gemäß Anspruch 1 umfasst und wobei die hydrophile Schicht mit niedrigem Index vorgesehen ist auf einer lichteinfallenden Seite eines vorderseitigen Glassubstrats der Photovoltaikvorrichtung.

## Revendications

1. Procédé de fabrication d'un article revêtu ayant un revêtement de bas indice ayant des propriétés antireflet et hydrophiles, le procédé comprenant :
la formation d'un sol de silice par mélange de glycydoxypropyltriméthoxysilane avec au moins un premier solvant, un premier catalyseur, de l'eau, et une silice colloïdale ;
la formation d'un sol d'oxyde de titane par mélange de tétra-isobutoxyde de titane avec au moins un second solvant, un second catalyseur, et de l'eau ;
le mélange du sol de silice et du sol d'oxyde de titane, le sol de silice et le sol d'oxyde de titane étant présents dans le mélange dans un rapport en poids entre 90:10 et 80:20 ;
le coulage du mélange par dépôt à la tournette pour former un revêtement sur un substrat de verre ;
le durcissement et le traitement à la chaleur du revêtement sur le substrat de manière à former une couche hydrophile de bas indice sur le substrat ;
dans lequel, à l'issue du traitement à la chaleur, une goutte d'eau sessile en contact avec la couche hydrophile de bas indice affiche un angle de contact inférieur ou égal à 25 degrés.

2. Procédé selon la revendication 1, dans lequel le premier solvant et le second solvant comprennent du n-propanol.

3. Procédé selon la revendication 1, dans lequel le premier catalyseur et le second catalyseur comprennent de l'acide chlorhydrique.

4. Procédé selon la revendication 1, dans lequel l'angle de contact est inférieur ou égal à 20 degrés, de préférence l'angle de contact est inférieur ou égal à 15 degrés, et de manière préférée entre toutes l'angle de contact est inférieur ou égal à 10 degrés.

5. Procédé selon la revendication 1, dans lequel le substrat de verre comprend du verre flotté.

6. Procédé de fabrication d'un dispositif photovoltaïque comprenant un film de transfert photoélectrique, au moins une électrode, et un revêtement de bas indice, dans lequel le procédé de fabrication du dispositif photovoltaïque comprend la fabrication de l'article revêtu selon la revendication 1, et dans lequel la couche de bas indice et hydrophile est ménagée sur un côté incidence de lumière d'un substrat de verre frontal du dispositif photovoltaïque.
